# EUROPÄISCHE PATENTANMELDUNG

(11) **EP 2 390 893 A1**
(43) Veröffentlichungstag der Anmeldung: **30.11.2011**
(21) Anmeldenummer: 11004093.8
(22) Anmeldetag: 18.05.2011
(51) Int. Cl.: H01H 36/00, H03K 17/97

(54) **Magnetschalter**

(30) Priorität: 29.05.2010 DE 102010022008
(71) Anmelder: Kissling Elektrotechnik GmbH, 72218 Wildberg (DE)
(72) Erfinder: Stiltz, Winfried, 73492 Rainau (DE); Uhlig, Christian, 72631 Aichtal (DE); Weirowski-Herz, Achim, 72202 Nagold (DE); Hengstler, Roland, 72108 Rottenburg (DE)
(74) Vertreter: Kohler Schmid Möbus

(57) **Zusammenfassung**

Die Erfindung betrifft einen Magnetschalter (1) mit:
- einem beweglich zwischen zwei Schaltpositionen gelagerten Aufnehmer mittels dem der Magnetschalter (1) betätigbar ist,
- einem Gehäuse (5) zu dem der Aufnehmer relativ beweglich gelagert ist,
- einem Magneten (11),
- einem mit dem Magneten (11) zusammenwirkenden Magnetsensor (33),
- einer dem Magnetsensor (33) zugeordneten Auswerteelektronik (23) mittels der ein von den Schaltpositionen des Aufnehmers abhängiges Schaltsignal erzeugbar ist.

Um einen verbesserten Magnetschalter bereitzustellen ist vorgesehen, dass der Magnetschalter (1) eine magnetische Abschirmung aufweist, die in Wechselwirkung mit dem Magnet (11) steht, wobei die Abschirmung und der Magnet (11) abhängig von den Schaltpositionen des Aufnehmers unterschiedliche relative Positionen zueinander aufweisen und die Auswerteelektronik und das Schaltsignal in Abhängigkeit der relativen Positionen erzeugt.

## Beschreibung

Die Erfindung betrifft einen Magnetschalter mit einem beweglich zwischen zwei Schaltpositionen gelagerten Aufnehmer mittels dem der Magnetschalter betätigbar ist, einem Gehäuse zu dem der Aufnehmer relativ beweglich gelagert ist, einem Magneten, einem mit dem Magneten zusammenwirkenden Magnetsensor, einer dem Magnetsensor zugeordneten Auswerteelektronik mittels der ein von den Schaltpositionen des Aufnehmers abhängiges Schaltsignal erzeugbar ist.

Magnetschalter sind bekannt. Sie weisen üblicherweise einen Magneten und eine mit dem Magneten zusammenwirkende Auswerteelektronik auf, wobei beispielsweise der Magnet abhängig von einer Betätigung beweglich gelagert ist und dessen Bewegungen mittels einer zugeordneten Auswerteelektronik zum Erzeugen eines Schaltsignals detektierbar sind. Die DE 10 2007 031 886 A1 betrifft ein Hausgerät mit einer Tür, die mittels einer Schließeinrichtung arretierbar ist und mit einer Türschlossstellungserfassungseinrichtung, die wenigstens einen Permanentmagneten und einen Magnetschalter aufweist, der durch Bewegen der Tür in dem Wirkungsbereich des Permanentmagneten bringbar ist. Es ist vorgesehen, dass der Magnetschalter ein Hall-Sensor ist.

Aufgabe der Erfindung ist es, einen verbesserten Magnetschalter bereitzustellen, insbesondere eine kompaktere Bauweise und/oder eine höhere Betriebssicherheit zu ermöglichen.

Die Aufgabe ist bei einem Magnetschalter mit einem beweglich zwischen zwei Schaltpositionen gelagerten Aufnehmer mittels dem der Magnetschalter betätigbar ist, einem Gehäuse zu dem der Aufnehmer relativ beweglich gelagert ist, einem Magneten, einem mit dem Magneten zusammenwirkenden Magnetsensor, einer dem Magnetsensor zugeordneten Auswerteelektronik mittels der ein von den Schaltpositionen des Aufnehmers abhängiges Schaltsignal erzeugbar ist dadurch gelöst, dass der Magnetschalter eine magnetische Abschirmung aufweist, die in Wechselwirkung mit dem Magnet steht, wobei die Abschirmung und der Magnet abhängig von den Schaltpositionen des Aufnehmers unterschiedliche relative Positionen zueinander aufweisen und die Auswerteelektronik das Schaltsignal in Abhängigkeit der relativen Position erzeugt. Es kann eine vergleichsweise kompakte Bauweise des Magnetschalters gewährleistet werden, da bereits vergleichsweise kleine relative Verlagerungen des Magnets zu der Abschirmung eine vergleichsweise große Änderung eines den Magneten umgebenden Magnetfelds bewirkt, wobei vorteilhaft die Änderung des Magnetfelds von dem Magnetsensor detektierbar ist.

Bei einem Ausführungsbeispiel des Magnetschalters ist vorgesehen, dass das Gehäuse die magnetische Abschirmung aufweist. Vorteilhaft weist das Gehäuse die magnetische Abschirmung auf, so dass das Gehäuse zwei Funktionen gleichzeitig erfüllen kann. Neben der Funktion einer Behausung von Bauelementen des Magnetschalters, kann die zusätzliche Funktion einer der Schaltfunktion dienenden lokalen Abschirmung direkt von dem Gehäuse übernommen werden, was eine besonders kompakte Bauweise des Magnetschalters ermöglicht.

Bei einem weiteren Ausführungsbeispiel des Magnetschalters ist vorgesehen, dass der Magnetschalter als Stößelschalter ausgeführt ist, wobei der Aufnehmer ein betätigbarer Stößel des Stößelschalters ist. Vorteilhaft kann über den Stößel die Betätigung des Magnetschalters erfolgen.

Bei einem weiteren Ausführungsbeispiel des Magnetschalters ist vorgesehen, dass der Magnet ein Ringmagnet ist, der in einer die Abschirmung bildenden Stufenbohrung zusammen mit dem Stößel längs verschieblich gelagert ist. Vorteilhaft kann die Stufenbohrung eine Gleitlagerung für den Stößel und die Abschirmung des Magneten bilden. Dazu kann das Gehäuse vorteilhaft ein Magnetfeldlinien abschirmendes Material aufweisen.

Bei einem Ausführungsbeispiel des Magnetschalters ist vorgesehen, dass die Stufenbohrung einen ersten Durchmesser aufweist, in dem der Stößel längs verschieblich gelagert ist, einen zweiten, sich an den ersten Durchmesser anschließenden größeren Durchmesser aufweist, in dem der Magnet längs verschieblich gelagert ist und einen größeren als der zweite Durchmesser dritten Durchmesser aufweist, in dem der Magnetsensor angeordnet ist. Vorteilhaft kann die Stufenbohrung auf einfache Art und Weise in das Gehäuse des Stößelschalters eingebracht werden. Der zweite Durchmesser bildet vorteilhaft die Abschirmung, wobei der dritte Durchmesser vorteilhaft einen Freiraum bilden kann, der von Feldlinien des Magneten leicht durchsetzbar ist. Sobald der Magnet von der Abschirmung weg in den dritten Durchmesser hineinbewegt wird, wird der Freiraum mit Feldlinien durchsetzt, was mittels des Magnetsensors detektierbar ist.

Bei einem weiteren Ausführungsbeispiel des Magnetschalters ist vorgesehen, dass die Auswerteelektronik, den Magnetsensor aufweist und in dem dritten Durchmesser der Stufenbohrung gelagert ist. Vorteilhaft ist auch die Auswerteelektronik in dem dritten Durchmesser aufgenommen und als integriertes Bauteil zusammen mit dem Magnetsensor ausgeführt.

Bei einem weiteren Ausführungsbeispiel des Magnetschalters ist vorgesehen, dass die Auswerteelektronik nach einer Versorgungsstromunterbrechung eine Eigendiagnose durchführt. Vorteilhaft steht ein eine Funktion des Magnetschalters kennzeichnendes Signal zur Verfügung.

Die Aufgabe ist ferner bei einem Kraftfahrzeug mit einem vorab beschriebenen Magnetschalter gelöst. Es ergeben sich die vorab beschriebenen Vorteile.

Weitere Vorteile, Merkmale und Einzelheiten ergeben sich aus der nachfolgenden Beschreibung, in der - gegebenenfalls unter Bezug auf die Zeichnung - zumindest ein Ausführungsbeispiel im Einzelnen beschrieben ist. Beschriebene und/oder bildlich dargestellte Merkmale bilden für sich oder in beliebiger, sinnvoller Kombination den Gegenstand der Erfindung, gegebenenfalls auch unabhängig von den Ansprüchen, und können insbesondere zusätzlich auch Gegenstand einer oder mehrerer separaten Anmeldung/en sein. Gleiche, ähnliche und/oder funktionsgleiche Teile sind mit gleichen Bezugszeichen versehen. Es zeigen:
- Fig. 1: einen Längsschnitt eines als Magnetschalter ausgelegten Stößelschalters;
- Fig. 2: eine schematische Ansicht einer Schaltanordnung des in Figur 1 gezeigten Stößelschalters;
- Fig. 3: ein Diagramm eines Sensorsignals des in Figur 1 gezeigten Magnetschalters über der Zeit; und
- Fig. 4: das in Figur 3 gezeigte Diagramm, wobei im Unterschied ein zeitlicher Verlauf des Sensorsignals während und nach zwei durchgeführten Eigendiagnosen aufgetragen ist.

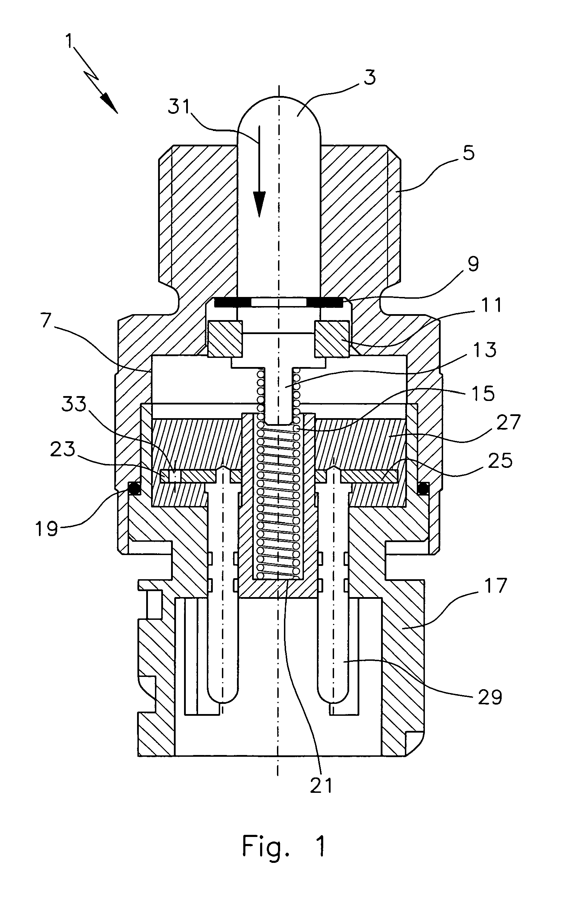

Figur 1 zeigt einen Längsschnitt eines Magnetschalters 1, der als Stößelschalter ausgelegt ist. Der Magnetschalter 1 weist einen zwischen zwei Schaltpositionen verlagerbaren, als Stößel 3 ausgebildeten Aufnehmer auf, der dazu in einem Gehäuse 5 längs verschieblich gelagert ist.

Der Stößel 3 ist in einer Stufenbohrung 7 des Gehäuses 5 aufgenommen. Im Bereich des Stößels 3 weist die Stufenbohrung 7 einen ersten kleinsten Durchmesser auf, der in einem zweiten größeren Durchmesser übergeht. Der zweite größere Durchmesser geht in einen dritten noch größeren Durchmesser über. Der dritte Durchmesser geht schließlich in einen vierten größeren und einen fünften größeren Durchmesser über. Insgesamt weist die Stufenbohrung 7 des Gehäuses 5 vier Stufen und fünf Durchmesser auf. Alternativ und/oder zusätzlich ist es möglich, anstelle der zylindrischen Stufenbohrung 7 einen beliebigen Querschnitt, beispielsweise einen rechteckig gestuften Querschnitt zu verwenden.

An einer Stufe der Stufenbohrung 7 zwischen dem ersten Durchmesser und dem zweiten Durchmesser schlägt eine Sicherungsscheibe 9 an, die formschlüssig fest dem Stößel 3 zugeordnet ist. Die Sicherungsscheibe 9 kann beispielsweise als Sprengring ausgeführt sein, der in einer entsprechenden umlaufenden Nut des Stößels 3 eingeclipst werden kann.

An einem inneren Ende weist der Stößel 3 eine Stufe auf, in die ein als Ringmagnet ausgeführter Magnet 11 eingreift. Ein gestufter, tellerförmiger Magnethalter 13 umschließt den Magnet 11 von einer dem Stößel 3 gegenüberliegenden Seite her, so dass der Magnet 11 formschlüssig zwischen der Stufe des Stößels 3 und einer Stufe des Magnethalters 13 fixiert ist.

Der Magnethalter 13 weist auf einer dem Magneten 11 gegenüberliegenden Seite einen Federdorn auf, auf dem eine Druckfeder 15 gelagert ist. Die Druckfeder 15 presst den Magnethalter 13 gegen den Magneten 11, den Magnet 11 gegen die Stufe des Stößels 3 und schließlich die Sicherungsscheibe 9 gegen die Stufe zwischen dem ersten und zweiten Durchmesser der Stufenbohrung 7 des Gehäuses 5. In Figur 1 ist diese Position gezeigt, die einer Nichtbetätigung des Magnetschalters 1 entspricht.

Das Gehäuse 5 weist ein Oberteil auf, in das die Stufenbohrung eingebracht ist. Ferner weist das Gehäuse 5 ein als Bajonett-Stecker 17 ausgeführtes Unterteil auf, das in die Stufenbohrung 7 form-, reib-, und/oder kraftschlüssig eingreift. Ferner ist zum Abdichten des Oberteils und des Unterteils des Gehäuses 5 an einer vierten Stufe, also zwischen dem vierten Durchmesser und fünften Durchmesser der Stufenbohrung 7 ein Dichtring 19 angeordnet.

Der Bajonett-Stecker 17 weist auf einer Innenseite eine Sacklochbohrung 21 auf, die eine Federaufnahme für die Druckfeder 15 und an einem Bohrgrund ein Gegenlager bzw. ein Federanschlag für die Druckfeder 15 bildet, so dass sich die Druckfeder 15 an dem Magnethalter 13 und an dem Bohrgrund der Sacklochbohrung 21 abstützt bzw. diese mit einer Federkraft beaufschlagt und damit auseinanderdrückt.

Ferner ist im inneren des Bajonett-Steckers 17 eine Auswerteelektronik 23 mit einer Platine 25 angeordnet. Die Platine 25 ist mit einer Vergussmasse 27 vergossen und mittels der Vergussmasse 27 innerhalb des Bajonett-Steckers 17 bzw. des Gehäuses 5 fixiert.

Zwischen der Vergussmasse 27 und dem Magnethalter 13 bzw. dem Magneten 11 verbleibt ein Freiraum, in dem sich der Magnet 11 bei einer Betätigung des Stößels 3 hineinbewegt. Der Freiraum wird durch den dritten Durchmesser der Stufenbohrung 7 gebildet. Die Vergussmasse und die Platine 25 befinden sich ebenfalls in dem dritten Durchmesser, wobei dieser durch den Bajonett-Stecker 17 fortgesetzt wird. Der Freiraum und die Vergussmasse können leicht mit Feldlinien des Magneten 11 durchsetzt werden.

Zur Kontaktierung der Platine 25 der Auswerteelektronik 23 sind dieser zwei Steckerstifte 29 des Bajonett-Steckers 17 zugeordnet. Über die Steckerstifte 29 des Bajonett-Steckers 17 kann der elektronische Magnetschalter 1 kontaktiert werden. Die Steckerstifte 29 bilden eine Zweidrahtschnittstelle zum Auslesen einer Schaltposition des Magnetschalters 1.

Wie in Figur 1 dargestellt, ist der Magnetschalter 1 in einer ersten Schaltposition gezeigt. In der ersten Schaltposition befindet sich der Magnet 11 innerhalb des zweiten Durchmessers der Stufenbohrung 7 des Gehäuses 5. Das Gehäuse 5 kann ein Magnetfeldlinien abschirmendes Material aufweisen. Es ist ersichtlich, dass in der in Figur 1 gezeigten ersten Schaltposition der Magnet 11 weitestgehend abgeschirmt ist. In einer zweiten Schaltposition, die durch ein Niederdrücken des Stößels 3 in Richtung eines Pfeils 31 erzeugt werden kann, befindet sich der Magnet 11 in einer zweiten relativen Position zu dem Gehäuse 5, wobei der Magnet 11 in den Freiraum des dritten Durchmessers der Stufenbohrung 7 des Gehäuses 5 hineinbewegt wird, wobei vorteilhaft Magnetfeldlinien des Magnets 11 frei werden, so dass diese auch die Platine 25 der Auswerteelektronik 23 durchdringen. Zum Feststellen dieser Änderung ist auf der Platine 25 der Auswertelektronik 23 ein Magnetsensor 33 integriert. Vorteilhaft kann der Magnetsensor 33 die Änderung des Magnetfelds innerhalb des Freiraums des Gehäuses 5 detektieren, wobei eine entsprechende Schaltposition bzw. Betätigungsposition des Stößels 3 über die Zweidrahtschnittstelle der zwei Steckerstifte 29 ausgebbar ist. Der Stößel 3 steilt also einen Aufnehmer zum Erfassen der zwei Schaltpositionen des Magnetschalters 1 dar.

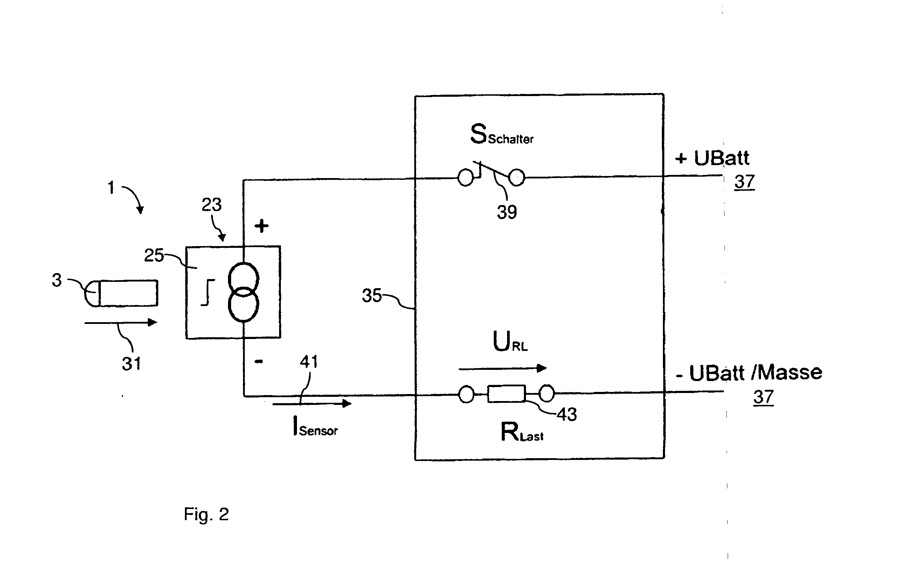

Figur 2 zeigt eine schematische Ansicht einer Schaltanordnung des in Figur 1 gezeigten Magnetschalters 1.

Mittels des Pfeils 31 ist schematisch die Bewegungsrichtung des längs verschieblichen Stößels 3 angedeutet. Der Stößel 3 wird über den nicht näher dargestellten Magnet 11 auf den Magnetsensor 33, der vorteilhaft als Hall-Sensor ausgeführt ist. Der Hall-Sensor erzeugt vorteilhaft ein von einer Bewegung des Magneten 11 relativ zu dem Magnetsensor 33 unabhängiges Signal bzw. eine lediglich von einer Feldstärke abhängige Spannung. Vorteilhaft kann der Magnetsensor 33, der sich auf der Platine 25 der Auswerteelektronik 23 innerhalb des Gehäuses 5 des Magnetschalters 1 befindet über ein elektronisches Steuergerät mit elektrischer Energie versorgt und ausgelesen werden.

Dazu ist das elektronische Steuergerät 35 einer elektrischen Energiequelle 37 zugeordnet, die lediglich mittels des Bezugszeichens 37 in Figur 2 angedeutet ist. Bei der elektrischen Energiequelle 37 kann es sich beispielsweise um eine Batterie, insbesondere eine 12-Volt- oder 24-Volt-Batterie handeln.

Das elektronische Steuergerät 35 weist einen elektronischen Schalter 39 auf, der abhängig von der Schaltposition des Magnetschalters 1 bzw. von der relativen Position des Magneten 11 zu der als Abschirmung dienenden Stufenbohrung 7 des Gehäuses 5 einen Sensorstrom 41 auf die Zweidrahtschnittstelle der Steckerstifte 29 aufprägt. Ferner weist das elektronische Steuergerät 35 einen Lastwiderstand 43 auf, der von dem Sensorstrom 41 durchflossen wird. Vorteilhaft fällt an dem Lastwiderstand 43 eine entsprechende Spannung ab, die vorteilhaft zum Ermitteln der Schaltposition des Magnetschalters 1 ausgelesen werden kann. Der Sensorstrom 41 ist in Figur 2 mit dem Bezugszeichen Iₛₑₙₛₒᵣ symbolisiert. Die an dem Lastwiderstand 43 abfallende Spannung ist in Figur 2 mit dem Bezugszeichen U_{RL} gekennzeichnet. Der Lastwiderstand 43 selbst ist in Figur 2 mittels des Bezugszeichens R_{Last} gekennzeichnet. Eine elektrische Spannung der elektrischen Energiequelle 37 ist in Figur 2 mittels des Bezugszeichens +UBatt bzw. -Ubatt/Masse gekennzeichnet.

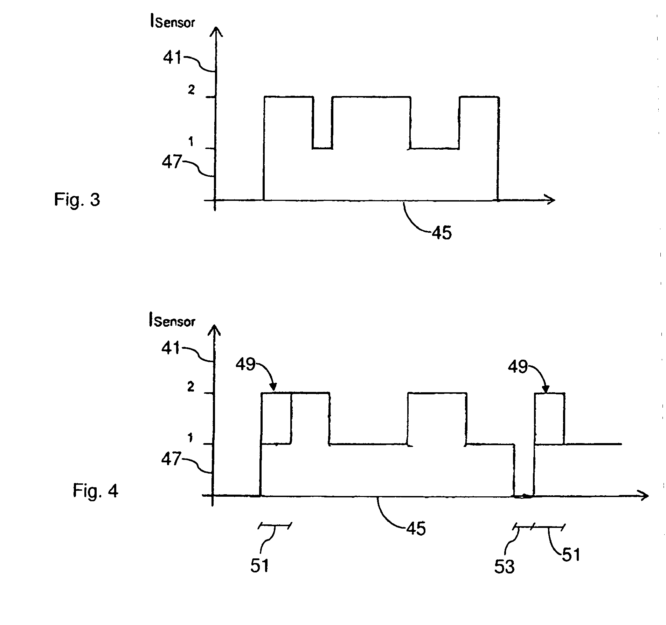

Figur 3 zeigt ein Schaubild des in Figur 2 symbolisierten Sensorstroms 41 über der Zeit. Dazu ist die Zeit auf einer x-Achse 45 und der Sensorstrom 41 auf einer y-Achse 47 aufgetragen. Es ist zu erkennen, dass zunächst kein Sensorstrom 41 durch die Zweidrahtschnittstelle der Steckerstifte 29 fließt. Dies entspricht einem ausgeschalteten Zustand des Magnetschalters 1, wobei die elektrische Energiequelle 37, beispielsweise mittels des elektronischen Schalters 39, von dem elektronischen Steuergerät und damit auch von der Auswerteelektronik 23 abgetrennt ist. Im weiteren Verlauf erfolgt ein Anstieg des Sensorstroms 41 auf einen Wert, der in Figur 3 beispielhaft mit der Ziffer 2 symbolisiert ist. Im weiteren Verlauf fällt an einer Flanke der Sensorstrom 41 auf einen Wert ab, der in Figur 3 mit der Ziffer 1 symbolisiert ist. Dies entspricht einem Wechsel des Magnetschalters 1 von der in Figur 1 gezeigten Schaltposition in eine betätigte Schaltposition. Im weiteren Verlauf ist ein entgegen gesetzter Wechsel der Schaltpositionen, also ein Anstieg des Sensorstroms 41 über der x-Achse 45 aufgetragen. Im weiteren Verlauf erfolgen zwei weitere Flanken, eine abfallende Flanke und eine ansteigende Flanke, die jeweils einen Wechsel der Schaltposition anzeigen und schließlich ein gänzliches Abfallen des Sensorstroms 41 auf einen Wert 0, was einem Abschalten des Magnetschalters 1, also einem Trennen von der elektrischen Energiequelle 37 entspricht.

Figur 4 zeigt einen zeitlichen Verlauf des Sensorstroms 41 analog der Darstellung der Figur 3. Als Unterschied zur Darstellung der Figur 3 sind in Figur 4 die Auswerteelektronik 23 und das elektrische Steuergerät 35 so ausgelegt, dass dieses nach einem Anschalten, also nach einem Anlegen der Spannung bzw. einem Verbinden mit der elektrischen Energiequelle 37 ein Selbsttest 49 durchgeführt wird. Der Selbsttest 49 nimmt eine fest definierte Zeitspanne 51 in Anspruch und gibt ein Ergebnis des Selbsttests 49 über die Zweidrahtschnittstelle der Steckerstifte 29 des Bajonett-Steckers 17 aus. Nach der Ausgabe des Ergebnisses des Selbsttests 49 wird eine aktuelle Schaltposition des Magnetschalters 1 ausgegeben. Dies ist im weiteren Verlauf von Figur 4 durch mehrere sich abwechselnd abfallende und ansteigende Flanken des Sensorstroms 41 symbolisiert. Der Selbsttest 49 wird nach einem erstmaligen Einschalten des Magnetschalters 1 durchgeführt.

Wie im weiteren Verlauf der Figur 4 ersichtlich, kann der Selbsttest 49 vorteilhaft auch nach einer Unterbrechung der Versorgungsspannung der elektrischen Energiequelle 37 für eine weitere Zeitspanne 53, die beispielsweise kürzer sein kann als die Zeitspanne 51, erneut durchgeführt werden.

Der Anschluss zur Energieversorgung bzw. zur elektrischen Quelle 37 und eine Signalübertragung erfolgt durch eine Zweidrahtleitung bzw. die Zweidrahtschnittstelle der zwei Steckerstifte 29. Der Schaltzustand bzw. die zwei Schaltpositionen des Magnetschalters 1 werden dabei durch einen Wechsel zwischen zwei eingeprägten Strömen des Sensorstroms 41, geschaltet durch den elektronischen Schalter 49, an ein entsprechendes Steuergerät übertragen. Fehler in Zuleitungen, wie beispielsweise Kurzschlüsse, wie beispielsweise ein Masseschluss, ein UB-Schluss und/oder Leitungsunterbrechungen können von dem Steuergerät vorteilhaft durch Überwachen dieser Ströme erkannt werden. Durch einen Verzicht auf mechanische Kontakte ist der Magnetschalter 1, der als elektronischer Stößelschalter ausgelegt ist, vorteilhaft geeignet eine sehr hohe Anzahl an Schaltwechseln, da über die ganze Lebensdauer konstante Eigenschaften zu erreichen. Die Stößelform des Stößels 3 ist so ausgeführt, dass bei Betätigung, ein-und austretende Flüssigmedien ungehindert abfließen können. Nach einem Anlegen der Versorgungsspannung der elektrischen Energiequelle 37 wird ein definierter Zeitraum bzw. die Zeitspanne 51 vorgehalten, um alternativ und/oder zusätzlich Informationsübertragungen, insbesondere für den Selbsttest 49, zu ermöglichen. Während der Zeitspanne 51 kann die Information über den Selbsttest 49 und/oder über einen Schaltertyp, beispielsweise ausgelegt als Öffner oder Schließer, an das Steuergerät übertragen werden. Nach Ablauf der Zeitspanne 51 wird der aktuelle Schaltzustand bzw. die entsprechende Schaltposition des Stößels 3 ausgegeben. Vorteilhaft kann durch den elektronischen Magnetschalter 1 ein mechanischer Stößelschalter ersetzt werden. Vorteilhaft ergibt sich eine vergleichsweise längere Haltbarkeit und eine vergleichsweise höhe Anzahl an Schaltwechseln. Vorteilhaft ergeben sich keine Kontaktveränderungen durch Verschleiß, eindringendes Öl und/oder fremde Stoffe, insbesondere ist vorteilhaft die die Platine 25 der Auswerteelektronik 23 schützende Vergussmasse 27 vorgesehen. Vorteilhaft kann der Magnetschalter 1 diagnosefähig ausgelegt sein, insbesondere eine übergeordnete Diagnosefunktion, beispielsweise eines Kraftfahrzeugs, in dem der Magnetschalter 1 eingebaut ist, unterstützen. Vorteilhaft erfolgt sowohl die Versorgung von der elektrischen Energiequelle 37 ausgehend und die Signalübertragung in Zweileitertechnik, also über die zwei Leitungen der Steckerstifte 29. Vorteilhaft ergibt sich ein insgesamt kompakter und einfacher Aufbau, wobei das Gehäuse 5 gleich und/oder sehr ähnlich ausgeführt ist wie bei alternativen mechanischen Stößelschaltern.

Der Stößel 3 wird durch die Druckfeder 15, den Magnethalter 13, dem Magneten 11 und der Sicherungsscheibe 9 in der Ruheposition gehalten. In der Ruheposition wird der Magnet 11 vom magnetisierbaren Gehäuse 5 so umschlossen, dass ein Magnetfeld des Magnets 11 kurzgeschlossen ist und Feldlinien im Wesentlichen im Magneten 11 selbst und im Gehäuse 5 verlaufen. Durch das Eindrücken des Stößels 3 wird der Magnet 11 aus der Umhüllung durch das Gehäuse 3 herausbewegt, was dazu führt, dass die magnetischen Feldlinien nicht mehr gebündelt sind sondern durch die Luft des Freiraums des zweiten Durchmessers der Stufenbohrung 7 des Gehäuses 5 verlaufen. Dies führt vorteilhaft in Folge zu einem steilen Anstieg der magnetischen Feldstärke im Bereich des als Hall-Sensors ausgelegten Magnetsensors 33, der sich auf der Platine 25 der Auswerteelektronik 23 befindet. Bei Überschreiten einer vorgegebenen Schwelle wird diese Position des Stößels 3 von einer entsprechenden Elektronik auf der Platine 25 als Schalter betätigt ausgewertet und der eingeprägte Strom bzw. Sensorstromm 41 in der Zweidrahtschnittstelle der Steckerstifte 29 vorn unbetätigten auf den betätigten Zustand umgeschaltet. Diese mechanische Anordnung vom Stößel 3, dem Magnet 11 und dem Gehäuse 5 erlaubt, dass ein Schaltpunkt für einen Wechsel vom unbetätigten auf den betätigten Zustand durch die geometrische Auslegung des Gehäuses 5, insbesondere der Stufenbohrung 7 des Gehäuses 5, bestimmt wird und kein individueller Abgleich des Schaltpunktes notwendig ist.

Die Ausgabe des Schaltzustands bzw. der aktuellen Schaltposition des Stößels 3 erfolgt über die Zweidrahtschnittstelle in der Art, dass wenn an die beiden Anschlüsse der Steckerstifte 29 eine Spannung in richtiger Polarität angelegt wird über den Schalter ein dem Schaltzustand entsprechender konstanter Laststrom bzw. der Steuerstrom 41 fließt. Vorzugsweise ist der Strom des einen Zustands doppelt so groß wie der des anderen. Zur Auswertung des Schaltzustands durch das angeschlossene Steuergerät genügt es, wenn in den Stromkreis ein geeigneter Prüfwiderstand eingeschleust, wie beispielsweise der Lastwiderstand 43. An dem Lastwiderstand steht dann entsprechend des Schaltzustandes eine die Spannung U_{RL} an. Da der Schaltzustand einen von zwei möglichen Strömen zugeordnet ist, ist es möglich über die am Prüfwiderstand anstehende Spannung auf die Funktion des elektronischen Schalters um mögliche Fehler in den Verbindungsleitungen zu schließen, beispielsweise einen Kurzschluss, wie einen UB-Schluss, einen MasseSchluss und/oder eine Unterbrechung von der Versorgungsspannung in der elektrischen Energiequelle 37.

Alternativ und/oder zusätzlich ist es möglich, den Magnetschalter 1 mit einem Selbsttest bzw. einer Eigendiagnose auszulegen. Durch Integration der elektronischen Komponenten im integrierten Schaltkreis ist es möglich, sehr viele Funktionen auf kleinstem Raum zusammenzufassen. So ist es möglich, der Elektronik des elektronischen Stößelschalters bzw. des Magnetschalters 1 alternativ und/oder zusätzlich zu einem Analog/Digital-Wandler und/oder einem Mikrocontroller zu erweitern. Diese können die Funktion des elektronischen Stößelschalters oder einzelne wichtige Komponenten, wie z.B. den Hall-Sensor des Magnetsensors 33 auf ihre Funktion überwachen. Um das Ergebnis dieser Überwachung dem angeschlossenen Steuergerät mitzuteilen, kann der Strom bzw. der Sensorstrom 41 durch den Magnetschalter 1 für eine kurze Zeitspanne, beispielsweise ein definierter Teil der Zeitspanne 51, entsprechend dem Ergebnis des Selbsttests, in Ordnung oder nicht in Ordnung, einer der möglichen Stromstärken zugeordnet und ausgegeben werden. Danach kehrt der Magnetschalter 1 wieder zur Ausgabe des aktuellen Schaltzustands bzw. der Schaltposition des Stößels 3 zurück. Um das Ergebnis des Selbsttests 49 auszugeben wird die feste Zeitspanne 51 nach dem die Versorgungsspannung der elektrischen Energiequelle 37 angelegt wurde, verwendet. Im Betrieb kann dann durch ein kurzes Abschalten der Versorgungsspannung der Selbsttest 49 erneut gestartet werden (Figur 4).

Alternativ und/oder zusätzlich ist es möglich, einen gepulsten Betrieb des elektronischen Stößelschalters vorzusehen. Generell ist auch möglich, den elektronischen Stößelschalter bzw. den Magnetschalter 1 nur für kurze Zeit einzuschalten und die Information über den Selbsttest und danach die Position bzw. Schaltposition des Stößels 3 abzufragen und den Magnetschalter 1 danach wieder abzuschalten. Vorteilhaft führt diese Betriebsart zu einem wesentlich geringeren mittleren Energieverbrauch, was ein Bordnetz eines nicht näher dargestellten Kraftfahrzeugs, das den Magnetschalter 1 aufweist, beispielsweise bei einem Stillstand eines Verbrennungsmotors des Kraftfahrzeugs vorteilhaft entlastet. Dabei kann das Bordnetz durch die elektrische Energiequelle 37 länger mit elektrischer Energie versorgt werden. Weiter entsteht in elektrischen Bauteilen des Magnetschalters 1 eine wesentlich geringere Verlustleistung, wobei sich eine geringere thermische Belastung der Komponenten, beispielsweise der Platine 25 und der Auswerteelektronik 23 ergeben, wobei eine Lebensdauer der Komponenten vorteilhaft verlängert werden kann, insbesondere bei vergleichsweise hohen Umgebungstemperaturen.

Alternativ und/oder zusätzlich ist es denkbar, dass der Magnet 11 dem Gehäuse 5 fest zugeordnet ist und dem Stößel 3 eine separate, zusammen mit dem Stößel 3 beweglich gelagerte und mit dem Magnet 11 wechselwirkende Abschirmung zugeordnet ist.

### Bezugszeichenliste

- 1: Magnetschalter
- 3: Stößel
- 5: Gehäuse
- 7: Stufenbohrung
- 9: Sicherungsscheibe
- 11: Magnet
- 13: Magnethalter
- 15: Druckfeder
- 17: Bajonett-Stecker
- 19: Dichtring
- 21: Sacklochbohrung
- 23: Auswerteelektronik
- 25: Platine
- 27: Vergussmasse
- 29: Steckerstifte
- 31: Pfeil
- 33: Magnetsensor
- 35: Steuergerät
- 37: Energiequelle
- 39: elektronischer Schalter
- 41: Sensorstrom
- 43: Lastwiderstand
- 45: x-Achse
- 47: y-Achse
- 49: Selbsttest
- 51: Zeitspanne
- 53: weitere Zeitspanne

## Patentansprüche

1. Magnetschalter (1) mit:
- einem beweglich zwischen zwei Schaltpositionen gelagerten Aufnehmer mittels dem der Magnetschalter (1) betätigbar ist,
- einem Gehäuse (5) zu dem der Aufnehmer relativ beweglich-gelagert-ist,
- einem Magneten (11),
- einem mit dem Magneten (11) zusammenwirkenden Magnetsensor (33),
- einer dem Magnetsensor (33) zugeordneten Auswerteelektronik (23) mittels der ein von den Schaltpositionen des Aufnehmers abhängiges Schaltsignal erzeugbar ist,
**dadurch gekennzeichnet, dass**
der Magnetschalter (1) eine magnetische Abschirmung aufweist, die in Wechselwirkung mit dem Magnet (11) steht, wobei die Abschirmung und der Magnet (11) abhängig von den Schaltpositionen des Aufnehmers unterschiedliche relative Positionen zueinander aufweisen und die Auswerteelektronik und das Schaltsignal in Abhängigkeit der relativen Positionen erzeugt.

2. Magnetschalter nach dem vorhergehenden Anspruch,
**dadurch gekennzeichnet, dass**
das Gehäuse (5) die magnetische Abschirmung aufweist.

3. Magnetschalter nach einem der vorhergehenden Ansprüche,
**dadurch gekennzeichnet, dass**
der Magnetschalter (1) als Stößelschalter ausgelegt ist, wobei der Aufnehmer ein betätigbarer Stößel (3) des Stößelschalters ist.

4. Magnetschalter nach einem der vorhergehenden zwei Ansprüche,
**dadurch gekennzeichnet, dass**
der Magnet (11) ein Ringmagnet ist, der in einer die Abschirmung bildenden Stufenbohrung (7) zusammen mit dem Stößel (3) längs verschieblich gelagert ist.

5. Magnetschalter nach dem vorhergehenden Anspruch,
**dadurch gekennzeichnet, dass**
die Stufenbohrung (7) einen ersten Durchmesser aufweist, in dem der Stößel (3) aufgenommen ist, einen größeren zweiten Durchmesser aufweist, in dem der Magnet (11) aufgenommen ist, einen größeren dritten Durchmesser aufweist, in dem der Magnetsensor (33) aufgenommen ist.

6. Magnetschalter nach dem vorhergehenden Anspruch,
**dadurch gekennzeichnet, dass**
die Auswerteelektronik (23) den Magnetsensor (33) aufweist und in dem dritten Durchmesser der Stufenbohrung (7) aufgenommen ist.

7. Magnetschalter nach einem der vorhergehenden Ansprüche,
**dadurch gekennzeichnet, dass**
nach einem Anlegen einer Versorgungsspannung und/oder nach einer Unterbrechung der Versorgungsspannung ein Selbsttest (49) des Magnetschalters (1) durchführbar ist.

8. Kraftfahrzeug mit einem Magnetschalter (1) nach einem der vorhergehenden Ansprüche.
